# EUROPEAN PATENT SPECIFICATION

(11) **EP 1 533 633 B1**
(45) Date of publication and mention of the grant of the patent: **17.01.2007**
(21) Application number: 04027464.9
(22) Date of filing: 18.11.2004
(51) Int. Cl.: G02B 6/00, G02F 1/13357

(54) **Planar lighting device**
Planare Beleuchtungseinrichtung
Dispositif d'illumination planaire

(30) Priority: 21.11.2003 JP 2003393131
(43) Date of publication of application: 25.05.2005
(73) Proprietor: KABUSHIKI KAISHA TOYOTA JIDOSHOKKI, Kariya-shi, Aichi-ken (JP)
(72) Inventor: Takeuchi, Norihito, Kariya-shi Aichi-ken (JP)
(74) Representative: TBK-Patent

(56) References cited:
- EP-A- 0 507 447
- US-A- 3 780 357
- US-A- 4 168 102
- US-A- 5 142 192
- US-A- 5 754 159
- US-A1- 2002 122 144
- PATENT ABSTRACTS OF JAPAN vol. 2002, no. 11, 6 November 2002 (2002-11-06) -& JP 2002 214411 A (FUJITSU LTD), 31 July 2002 (2002-07-31)

## Description

The present invention relates to an optical member and a lighting apparatus.

A lighting apparatus for emitting light through an area has been known. Such a lighting apparatus includes a light emitting element such as a light emitting diode (LED), cold cathode tube or electroluminescent (EL) element as a light source. One lighting apparatus is an organic EL panel comprising an organic EL element provided on a transparent substrate. The organic EL panel can be used as backlight for a liquid crystal display apparatus.

The area of the light exit surface of the organic EL panel equals the projection area of an organic EL layer in the organic EL element. A further increase in size of the light exit surface of the organic EL panel is currently required, but it is not easy to meet the requirement by increasing the projection area of the organic EL layer. This is because the thickness of the organic EL layer is normally very small, i.e., about several tens to hundreds of nanometers, and it is thus difficult to uniformly form an organic EL layer having a large projection area with a good yield. Thus, it has been proposed that a plurality of cells each including one organic EL element be arranged on a plane to meet the requirement for increase in size of the display surface of the display apparatus and the light exit surface of the organic EL panel (e.g. see Japanese Patent Laid-Open No. 2001-52858).

However, a terminal and a wire for connecting an anode and a cathode of each organic EL element to an external power supply are usually placed on a periphery of the transparent substrate of the organic EL element. Accordingly, light from the organic EL element is not emitted from a section of the transparent substrate between adjacent organic EL elements. Thus, a lighting apparatus emitting light uniformly can not be obtained if a plurality of organic EL elements are simply arranged on a plane.

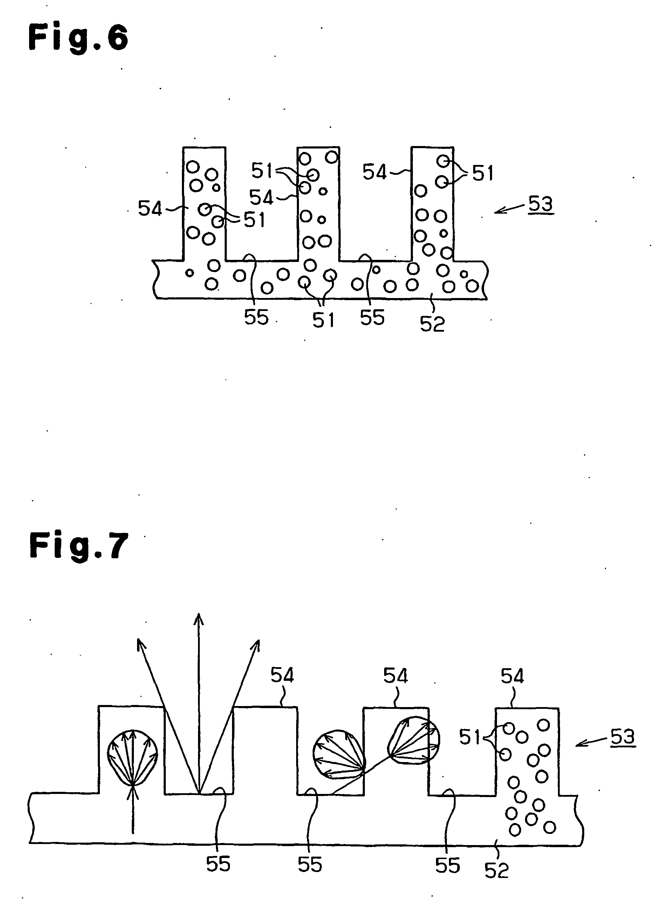

Japanese Laid-Open Patent Publication No. 2002-214411 discloses a lighting apparatus comprising an optical sheet or optical member, wherein the optical sheet or optical member has a plurality of raised portions for performing the function of scattering light. As shown in Figs. 6 and 7, the optical sheet comprises a base sheet section 52 and a diffusion section 53 composed of a plurality of raised portions 54. The raised portions 54 are mutually spaced. The base sheet section 52 and the raised portion 54 each include a scattering material 51. A trough 55 is provided between adjacent raised portions 54. An optical waveguide (not shown) is placed below the optical sheet, and light from the optical waveguide enters the base sheet section 52. A cross section of the raised portion 54 is a tetragon of 113 µm square, the height of the raised portion 54 is 60 µm, and the pitch between raised portions 54 is 195 µm. The optical member has a configuration the same as that of the optical sheet except that its thickness is larger than that of the optical sheet. The optical sheet and the optical member are used for reducing unevenness of luminance of light from the optical waveguide. In a lighting apparatus comprising the optical sheet or optical member, it is required to arrange the optical sheet or optical member and the light emitting element more satisfactorily.

Document US 5,142,192 A discloses a thin film electroluminescent element including a luminous layer for emitting light by applying a voltage to the luminous layer through an electrode, the electrode being made of a metal; and a material for scattering the light and disposed on an end face of the luminous layer. In the element, a plurality of luminous layers having different luminous wavelength characteristics are stacked with each other, and an insulating layer and a metallic electrode are disposed on both sides of the luminous layers. The light-scattering material mixes the lights emitted from the luminous layers with each other by the scattering of the lights and is disposed on the end faces of the luminous layers.

Furthermore, document US 4,168,102 A discloses a light-emitting display device comprising a printed wiring board impressed with a wiring pattern; a light-emitting element mounted on the printed wiring board and electrically connected to the wiring pattern; a reflector provided with a penetrating hole for receiving the light-emitting element at its lower opening and disposed on the printed wiring board, the inner wall of the penetrating hole acting as a reflection plane; a light-permeable film containing light-scattering materials and closing the upper opening of the penetrating hole; and a bonding layer containing light-scattering material, the bonding layer bonding the light-permeable film to the reflector.

Moreover, document US 2002/0122144 A1 discloses an illumination device and a manufacturing method therefor, a display device and an electronic instrument. An illumination device is provided that reduces the amount of light leaked and thus improves illumination efficiency.

Electroluminescent elements are formed on one surface of a transparent substrate. The electroluminescent elements are provided with at least a transparent electrode, a light emitting layer, and a reflective electrode in order from the outgoing surface of the transparent substrate. Concavities are formed on one surface of the transparent substrate and at least the reflective electrode is formed in the concavities.

Accordingly, it is an objective of the present invention to provide a lighting apparatus capable of emitting light in a suitable manner and to provide an optical member suitable for such a lighting apparatus.

According to the present invention, this object is solved by what is set forth in the appended claims.

Other aspects and advantages of the invention will become apparent from the following description, taken in conjunction with the accompanying drawings, illustrating by way of example the principles of the invention.

The invention, together with objects and advantages thereof, may best be understood by reference to the following description of the presently preferred embodiments together with the accompanying drawings in which:
Fig. 1 is a schematic sectional view of a lighting apparatus according to a first embodiment of the present invention;
Fig. 2 is a schematic plan view of the lighting apparatus shown in Fig. 1;
Fig. 3 is a schematic sectional view of the lighting apparatus according to a second embodiment of the present invention;
Fig. 4 is a schematic sectional view of the lighting apparatus according to another embodiment of the present invention;
Fig. 5 is a schematic plan view of an optical member provided in the lighting apparatus shown in Fig. 4;
Fig. 6 is a partial schematic view of an optical sheet according to prior art; and
Fig. 7 is a partial schematic view showing the action of the optical sheet shown in Fig. 6.

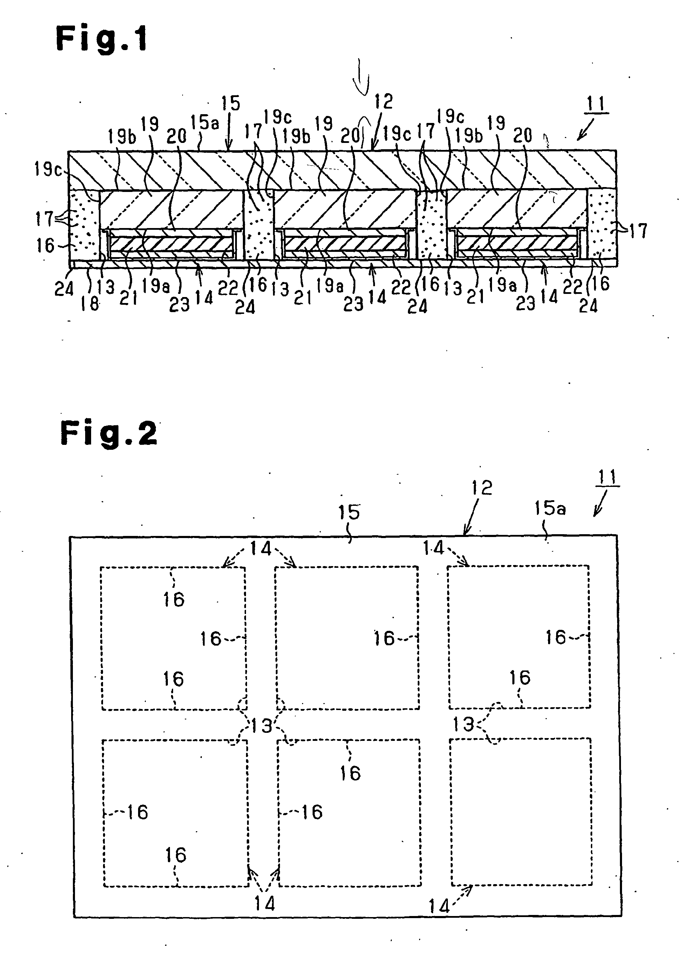

An optical member and a lighting apparatus according to the first embodiment of the present invention will now be described with reference to Figs. 1 and 2.

As shown in Fig. 1, a lighting apparatus 11 comprises an optical member 12 and a plurality of organic EL elements 14. Each organic EL element 14 is housed in a corresponding one of a plurality of housing sections 13 provided in the optical member 12 and functions as a light emitting element.

The optical member 12 comprises a substrate section 15 that permits light transmission and a guide section 16. The substrate section 15 comprises a light exit surface 15a, and the guide section 16 is provided on a surface of the substrate section 15 that faces away from the light exit surface 15a. In other words, the light exit surface 15a corresponds to a first surface which is one of first and second surfaces being on opposite sides of the substrate section 15, and the guide section 16 is provided on the second surface of the substrate section 15. The guide section 16 guides light, emitted from a side face of the organic EL element 14 housed in each housing section 13, to the substrate section 15.

The guide section 16 is integral with the substrate section 15. The substrate section 15 and the guide section 16 may be made of, for example, a transparent acrylic resin. In this specification, the term "transparent" means that at least visible light is allowed to pass.

The guide section 16 protrudes from the second surface of the substrate section 15. As shown in Fig. 2, the guide section 16 has a planar tetragonal frame shape corresponding to the planar tetragonal shape of the organic EL element 14. The housing sections 13 are defined by the substrate section 15 and the guide section 16. As shown in Fig. 1, the depth of each housing section 13 is almost equal to the thickness of the corresponding organic EL element 14. Openings of the housing sections 13 are closed with a bottom plate 18.

As shown in Fig. 1, each organic EL element 14 comprises a transparent substrate 19, a first electrode 20, an organic EL layer 21 and a second electrode 22. The first electrode 20, the organic EL layer 21 and the second electrode 22 are provided on the transparent substrate 19 in this order. Each organic EL element 14 is covered with a protective film 23 so that the organic EL layer 21 does not contact outside air. The protective film 23 functions to prevent permeation of at least moisture and oxygen. The protective film 23 may be made of, for example, silicon nitride. In each organic EL element 14, light emitted from the organic EL layer 21 is made to pass through the transparent substrate 19 to the outside. That is, each organic EL element 14 has a bottom emission structure. Organic EL elements 14 are electrically connected in series.

Each transparent substrate 19 is made of glass. Each transparent substrate 19 comprises an incident surface 19a and a light exit surface 19b being on opposite sides of the transparent substrate 19. The incident surface 19a of each transparent substrate 19 contacts the first electrode 20. Each organic EL element 14 is housed in the corresponding housing section 13 with the light exit surface 19b of the transparent substrate 19 facing the substrate section 15 and a side face 19c of the transparent substrate 19 contacting the guide section 16. The side face 19c of the transparent substrate 19 is at least part of the side face of the organic EL element 14. The light exit surface 15a of the substrate section 15 is orthogonal to the side face 19c of the transparent substrate 19.

Each first electrode 20 is made of a transparent conductive material such as indium tin oxide (ITO). The first electrode 20 functions as an anode.

Each organic EL layer 21 has a well known configuration. Each organic EL layer 21 may be composed of a hole injection layer, a light emitting layer and an electron injection layer arranged in this order from the first electrode 20 side, or may be composed of a hole injection layer, a hole transportation layer, a light emitting layer and an electron transportation layer arranged in this order from the first electrode 20 side. Light emitted from each organic EL layer 21 is white light.

Each second electrode 22 is made of a metal such as aluminum, and has light reflectivity. The second electrode 22 functions as a cathode.

The guide section 16 includes light scattering bodies 17. Each light scattering body 17 comprises an interface for scattering light emitted from the side face of the organic EL element 14 (more specifically, light exiting from the side face 19c of the transparent substrate 19 and entering the guide section 16). In this specification, "scattering" includes reflection and refraction. Each light scattering body 17 may be a scar or mark caused by application of laser light, or may be a portion of the guide section 16 different in refraction index from other portions of the guide section 16. The shape of each light scattering body 17 is not specifically limited, but may be appropriately designed according to the thickness and the width of the guide section 16, and may be, for example, spherical or circular in cross section. However, it is desirable that the light scattering bodies 17 should be capable of guiding light entering the guide section 16 toward the substrate section 15 efficiently.

The scattering bodies 17 may be formed by application of a laser marking method as disclosed in Japanese Laid-Open Patent Publication No. 2001-276985. According to the laser marking method, high-output laser light is converged into a transparent material, whereby degeneration of the transparent material associated with damage, a change in index of refraction and a change in density occurs only near a focal point. Thus, if the optical member 12 is placed on a stage capable of being moved three-dimensionally, and the optical member 12 is three-dimensionally moved while laser light is converged into the guide section 16 of the optical member 12 using a lens, the light scattering bodies 17 are formed at predetermined positions in the guide section 16.

For a laser light source, for example, an Nd-YAG laser is used. The laser light source is preferably a pulse laser because of easy control. As the pulse width of the laser decreases, it becomes easier to make the marking depth uniform. In this respect, a laser light source having a pulse width equal to or less than a subnano second (e.g. femtosecond laser having a pulse width in the order of 10 to 15 femtoseconds) is useful.

A light reflection film 24 functioning as a light reflection portion is provided at the end of guide section 16 located away from the substrate section 15, i.e., at the leading end of guide section 16. The light reflection film 24 is made of, for example, a metal such as aluminum.

The actual thickness of the transparent substrate 19 is, for example, about 0.5 to 1 mm, and the actual thicknesses of the first electrode 20, the organic EL layer 21 and the second electrode 22 are, for example, about several tens to 1000 nm. Thus, ratios of the thicknesses of the first electrode 20, the organic EL layer 21 and the second electrode 22 to the thickness of the transparent substrate 19 in Fig. 1 are different from those in actuality. The actual thickness of the protective film 23 is equal to or greater than the actual thicknesses of the first electrode 20, the organic EL layer 21 and the second electrode 22 but in Fig. 1, the thickness of the protective film 23 is smaller than the thicknesses of the first electrode 20, the organic EL layer 21 and the second electrode 22 for the sake of illustrative convenience. Relative sizes of the organic EL element 14, the substrate section 15, the guide section 16 and the transparent substrate 19 in Fig. 1 are also different from those in actuality. In this way, the relative size of each component of the lighting apparatus 11 shown in Fig. 1 is different from those in actuality.

Not only the light scattering bodies 17 of the guide section 16, but also the substrate section 15, performs the function for scattering light. However, the haze level of the substrate section 15 is set to be small so that the substrate section 15 does not scatter light more intensively than the light scattering bodies 17.

Operation of the lighting apparatus 11 shown in Fig. 1 will now be described.

The lighting apparatus 11 is placed on, for example, a back surface (surface opposite to the display surface) of a transmissive liquid crystal panel (not shown) and used as a backlight. When the lighting apparatus 11 is ON, a voltage is applied between the first electrode 20 and the second electrode 22 and as a result, the organic EL layer 21 emits light. Light emitted from the organic EL layer 21 enters the transparent substrate 19 through the first electrode 20. Among light entering the transparent substrate 19, light with the angle of incident to the light exit surface 19b smaller than the critical angle exits from the transparent substrate 19, and then enters the substrate section 15 of the optical member 12. Light with the angle of incidence to the light exit surface 19b larger than the critical angle is totally reflected on the light exit surface 19b, and therefore it does not exit from the transparent substrate 19 through the light exit surface 19b. The totally reflected light travels through the transparent substrate 19 toward the side face 19c, and exits from the transparent substrate 19 through the side face 19c. Thus, the organic EL element 14 emits light from not only the top face but also the side face.

The light exiting from the organic EL element 14 through the side face 19c enters the guide section 16 of the optical member 12. The light entering the guide section 16 is reflected or refracted at the light scattering bodies 17. Part of the light entering the guide section 16 travels toward the substrate section 15 as a result of reflection or refraction at the light scattering bodies 17, and then exits from the substrate section 15 through the light exit surface 15a. The light exiting from the substrate section 15 through the light exit surface 15a in this way is applied to a liquid crystal panel, and an image is displayed on the display surface of the liquid crystal panel.

In this way, in the lighting apparatus 11 shown in Fig. 1, not only light exiting from the top face of the organic EL element 14, but also light exiting from the side face of the organic EL element 14 are effectively used for display of images.

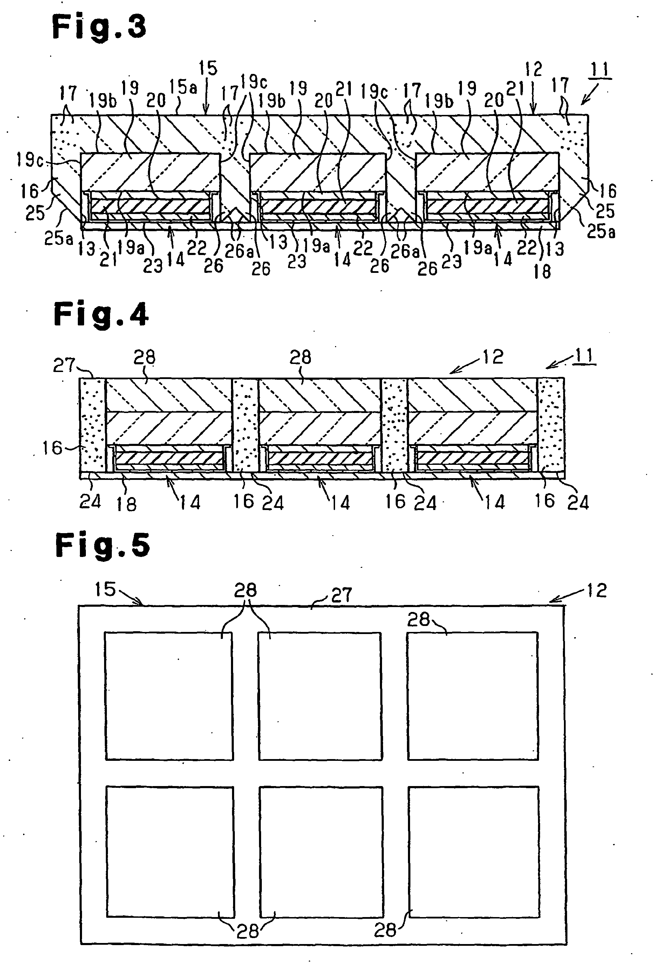

The first embodiment provides the following advantages.
(1) According to the lighting apparatus 11 shown in Fig. 1, light emitted from the side face of the organic EL element 14 is guided to the substrate section 15 by action of the guide section 16 to exit from the substrate section 15 through the light exit surface 15a. Thus, a larger amount of light exits from the substrate section 15 through the light exit surface 15a compared to the case where the guide section 16 is absent. The light guided to the substrate section 15 by the action of the guide section 16 exits from a portion of the substrate section 15 located between adjacent organic EL elements 14, and therefore unevenness of luminance between a portion of the substrate section 15 corresponding to each organic EL element 14 and a portion of the substrate section 15 located between adjacent organic EL elements 14 is reduced. According to the lighting apparatus 11, light can be made to exit uniformly from the substrate section 15 through the light exit surface 15a.
(2) The guide section 16 is integral with the substrate section 15. Thus, the optical member 12 is produced more easily compared to a configuration in which the guide section 16 is independent of the substrate section 15.
(3) The guide section 16 includes the light scattering bodies 17. Light emitted from the side face of the organic EL element 14 is guided to the substrate section 15 while being scattered and diffused by the light scattering bodies 17. Thus, the light guided to the substrate section 15 exits uniformly from the light exit surface 15a without the necessity to strongly scatter the light at the substrate section 15. On the other hand, if light entering the guide section 16 is simply guided to the substrate section 15 by a mirror surface, it is required to scatter light strongly at the substrate section 15 in order for the light to exit uniformly from the light exit surface 15a.
(4) The light reflection film 24 is provided at the leading end of the guide section 16. The light reflection film 24 reflects, toward the substrate section 15, at least part of the light reflected or refracted so as to travel away from the substrate section 15 at the light scattering bodies 17. Thus, a larger amount of light exits from the substrate section 15 through the light exit surface 15a compared to the case where the light reflection film 24 is absent and the surface of the leading end of the guide section 16 is optically absorptive or optically transparent.
(5) The organic EL element 14 is used as a light emitting element. Thus, reduction in thickness of the lighting apparatus 11 is more easily achieved compared to the case where a light emitting diode (LED) or cold cathode tube is used as a light emitting element.
(6) The organic EL element 14 has a bottom emission structure. Thus, light emitted from the side face of the organic EL element 14 is more efficiently guided to the substrate section 15 through the guide section 16 compared to an organic EL element having a top emission structure in which light emitted from the organic EL layer exits to the outside from a side opposite to the substrate.
(7) Organic EL elements 14 are electrically connected in series. Thus, the amounts of current passing through the organic EL elements 14 are the same, and the amounts of light emitted from the organic EL elements 14 are the same. Therefore, uniform light is easily made to exit from the light exit surface 15a.
(8) Light emitted from each organic EL layer 21 is white light. Thus, if the lighting apparatus 11 is used as a backlight for a liquid crystal panel, a full color display can be provided by using a color filter.
(9) The light scattering bodies 17 are formed by application of a laser marking method. Thus, the light scattering bodies 17 can be formed at predetermined positions in the guide section 16 without scratching or marking the surface of the guide section 16. Light scattering bodies 17 having various shapes can easily be formed at desired positions.
(10) Not only the light scattering bodies 17 of the guide section 16, but also the substrate section 15, performs the function for scattering light. Accordingly, light exiting from a portion of the light exit surface 15a corresponding to the guide section 16 is almost equivalent to light exiting from a portion of the light exit surface 15a not corresponding to the guide section 16.
(11) The second electrode 22 located away from the transparent substrate 19 compared to the first electrode 20 is optically reflective. Thus, the amount of light exiting from the light exit surface 19b of the transparent substrate 19 increases compared to the case where the second electrode 22 is not optically reflective.
   The second embodiment of the present invention will now be described with reference to Fig. 3. The same reference numerals are given to those components that are similar or the same as the corresponding components of the first embodiment, and detailed explanations are omitted.
   In the lighting apparatus 11 according to the second embodiment shown in Fig. 3, prisms 25 and 26 functioning as light reflection portions are provided at the end of the guide section 16. The prisms 25 and 26 are formed by notching the leading end of the guide section 16. The prism 25 provided in a portion of the guide section 16 located in the outer periphery of the optical member 12 is larger in size than the prism 26 provided in a portion of the guide section 16 located between housing sections 13. Specifically, the length of an inclined face 25a of the prism 25 is almost twice the length of the inclined face 26a of the prism 26. The angle between the inclined face 25a of the prism 25 and the side face of the guide section 16 is set so that the angle of incidence of light vertically entering the side face of the guide section 16 relative to the inclined face 25a of the prism 25 is larger than the critical angle. The angle between the inclined face 26a of the prism 26 and the side face of the guide section 16 is set so that the angle of incidence of light vertically entering the side face of the guide section 16 relative to the inclined face 26a of the prism 26 is larger than the critical angle.
   In Fig. 3, the thickness of a portion of the organic EL element 14 excluding the transparent substrate 19 is equal to the thickness of the transparent substrate 19 for the sake of convenience, and therefore the inclined faces 25a and 26a of the prisms 25 and 26, respectively, do not match the side face 19c of the transparent substrate 19 in location. However, in actuality, the thickness of a portion of the organic EL element 14 excluding the transparent substrate 19 is smaller than 1/100 of the thickness of the transparent substrate 19, and therefore the inclined faces 25a and 26a of the prisms 25 and 26, respectively, match the side face 19c of the transparent substrate 19 in location.
   In the lighting apparatus 11 according to the second embodiment, the guide section 16 does not include the light scattering bodies 17, but instead, a portion of the substrate section 15 corresponding to the guide section 16 includes the light scattering bodies 17.
   Light emitted from the transparent substrate 19 through the side face 19c enters the guide section 16, and then travels through the guide section 16 toward the inclined face 25a or 26a. The light arriving at the inclined face 25a or 26a is totally reflected toward the substrate section 15 at almost a right angle to the light exit surface 15a of the substrate section 15. Thereafter, the light is scattered by the light scattering bodies 17 of the substrate section 15 to diffuse almost uniformly, and then exits from the light exit surface 15a.
   The second embodiment provides the following advantages in addition to advantages (1), (2), (5) to (8), (10) and (11).
(12) Light emitted from the side face of organic EL element 14 enters the guide section 16 and is then guided to the substrate section 15 by the action of the prisms 25 and 26. Thus, the light entering the guide section 16 is efficiently guided to the substrate section 15 even if the light reflection film 24 shown in Fig. 1 is absent.
(13) A portion of the substrate section 15 corresponding to the guide section 16 includes the light scattering bodies 17. Thus, light guided to the substrate section 15 is scattered by the light scattering bodies 17 to exit uniformly from the light exit surface 15a.

It should be apparent to those skilled in the art that the present invention may be embodied in many other specific forms without departing from the scope of the invention, as defined in the appended claims. Particularly, it should be understood that the invention may be embodied in the following forms.

The substrate section 15 and the guide section 16 may be formed independently and then integrated. For example, as shown in Figs. 4 and 5, the optical member 12 may be composed of a lattice frame-shaped member 27 including light scattering bodies 17 and transparent members 28 fitted in meshes of lattices of the frame-shaped member 27. The top face of each transparent member 28 is flush with the top face of the frame-shaped member 27. In this case, the substrate section 15 is composed of a portion of the frame-shaped member 27 located in the periphery of the transparent member 28 and the transparent member 28, and the guide section 16 is composed of other portion of the frame-shaped member 27. The substrate section 15 has boundaries between the frame-shaped member 27 and the transparent members 28, but the boundaries are hardly seen when light exits from the light exit surface 15a of the substrate section 15. This is because the boundaries are hidden from view by light scattered by the light scattering bodies 17 included in a portion of the substrate section 15 corresponding to the guide section 16.

In the lighting apparatus 11 shown in Fig. 1, a light reflection film may be provided at least in a portion of the bottom plate 18 corresponding to the guide section 16, or the top face of the bottom plate 18 may be formed into a mirror face instead of providing the light reflection film 24 at the leading end of the guide section 16.

The optical member 12 may be formed by bonding a lattice frame-shaped member to a planar substrate. In this case, the substrate and the frame-shaped member may be bonded together with an adhesive or by welding.

The optical member 12 may be housed in a bottomed box-shaped housing instead of using the bottom plate 18. As a result, stability is improved compared to the case where the bottom plate 18 is used even if prisms 25 and 26 are provided at the leading end of the guide section 16.

The light reflection film 24 may be omitted.

The light reflection film may be provided on the outer face of the substrate section 15. The light reflection film preferably reflects light irregularly. In this case, at least part of the light exiting from the outer face of the substrate section 15 can be made to exit from the light exit surface 15a.

Each light scattering body 17 may have any shape as long as it has an interface for scattering light entering the guide section 16. For example, it may have a long and narrow shape extending along the thickness of the substrate section 15.

The scattering bodies 17 may not be necessarily formed by application of the laser marking method. For example, the light scattering bodies 17 may be formed by dispersing into the guide section 16 beads having an index of refraction different from that of the guide section 16.

Each organic EL element 14 may have a top emission structure instead of a bottom emission structure.

Light emitted from each organic EL element 14 is not limited to white light, but may be monochromatic light, or two or more colors of monochromatic light may be emitted. For example, each organic EL element 14 may emit red, blue, green or yellow monochromatic light. Alternatively, all organic EL elements 14 do not emit light of the same color, but some of the organic EL elements 14 may emit light different in color from light of other organic EL elements 14.

The planar shapes for the optical member 12 and the organic EL element 14 may be a square, rectangle, triangle, pentagon, other polygon, circle or sector form.

The shape of the optical member 12 is not limited to an analog of the organic EL element 14. For example, the optical member 12 may be tetragonal and the organic EL element 14 may be circular or triangle.

The optical member 12 may be made of a transparent resin other than a transparent acrylic resin, or glass.

A light emitting element other than the organic EL element 14, such as an inorganic EL element, LED or cold cathode tube, may be used. However, use of the organic EL element 14 or inorganic EL element can contribute to a reduction in thickness of the lighting apparatus 11 compared to use of an LED, cold cathode tube or the like.

A diffusion sheet (scattering sheet) may be provided on the light exit surface 15a of the lighting apparatus 11.

The first electrode 20 may be made of a transparent conductive material other than ITO, such as zinc oxide.

The first electrode 20 may be made transparent with a very thin metal foil. In this case, the thickness of the metal foil is preferably 50 nm or smaller, more preferably 0.5 to 20 nm.

The first electrode 20 may function as a cathode and the second electrode 22 may function as an anode. In this case, the configuration of the organic EL layer 21 is changed accordingly. Specifically, for example, the organic EL layer 21 is changed to be composed of an electron injection layer, a light emitting layer and a hole injection layer arranged in this order from the first electrode 20 side, or changed to be comprised of an electron injection layer, an electron transportation layer, a light emitting layer, a hole transportation layer and a hole injection layer arranged in this order from the first electrode 20 side.

The organic EL layer 21 may be composed only of a light emitting layer, or may be composed of at least one selected from the group consisting of a hole injection layer, a hole transportation layer, a hole injection and transportation layer, a hole blocking layer, an electron injection layer, an electron transportation layer, an electron injection and transportation layer and an electron blocking layer, and a light emitting layer.

The transparent substrate 19 may be made of a resin instead of glass. The transparent substrate 19 may be flexible if it is made of a resin. A transparent substrate 19 made of a resin is lighter than a transparent substrate 19 made of glass.

The lighting apparatus 11 may be used in applications other than for backlighting.

An optical member includes a substrate section (15) that permits light transmission. The substrate section has a light exit surface (15a). A guide section (16) is provided on a surface of the substrate opposite to the light exit surface. A plurality of housing sections (13) are defined by the guide section. Each housing section houses a light emitting element (organic electroluminescent element (14)). Light emitted from a side face of the light emitting element housed in each housing section is guided to the substrate section by the guide section. A lighting apparatus including the optical member can emit light in a suitable manner.

## Claims

1. A lighting apparatus including:
a plurality of light emitting elements (14) each including a top face and a side face; and
an optical member (12) comprising:
a substrate section (15) that permits light transmission having a first surface and a second surface, with the first surface and the second surface being on opposite sides of the substrate section (15), the first surface functioning as a light exit surface (15a);
a guide section (16) provided on the second surface of the substrate section (15); and
a plurality of housing sections (13)
**characterized in that**
the guide section has a frame shope defining the lateral side walls of the plurality of housing actions (13), and
each light emitting element (14) is housed in one of the housing sections (13) with the top face of the light emitting element (14) facing the substrate section (15) and the side face of the light emitting element (14) facing the guide section (16), and light emitted from the side faces of the light emitting elements (14) housed in housing sections (13) enters the guide section (16) and is guided to the substrate section (15) by the guide section (16) and then exits from the substrate section (15) through the light exit surface (15a) together with light emitted from the top faces of the light emitting elements (14).

2. The lighting apparatus according to claim 1, **characterized in that** the first surface is orthogonal to the side face of the light emitting element (14).

3. The lighting apparatus according to claim 1 or 2, **characterized in that** the guide section (16) is integral with the substrate section (15).

4. The lighting apparatus according to any one of claims 1 to 3, **characterized in that** the guide section (16) comprises light scattering bodies (17).

5. The lighting apparatus according to any one of claims 1 to 4, **characterized in that** the guide section (16) comprises a light reflection portion (24) located of the distal and relative to the substrate section (15), and a portion of the substrate section (15) corresponding to the frame shape of the guide section (16) comprises light scattering bodies (17).

6. The lighting apparatus according to any one of claims 1 to 5, **characterized in that** the substrate section (15) comprises a portion corresponding to the frame shape of the guide section (16) and a portion corresponding to a pattern of the lateral cross sections of the plurality of housing sections (13), and the portion of the substrate section (15) corresponding to the frame shape of the guide section (16) is configured to scatter light more intensively than the portion of the substrate section (15) corresponding to the pattern of the lateral cross sections of the plurality of housing sections (43).

7. The lighting apparatus according to any one of claims 1 to 6, **characterized in that** each light emitting element (14) is an inorganic electroluminescent element.

8. The lighting apparatus according to any one of claims 1 to 6, **characterized in that** each light emitting element (14) is an organic electroluminescent element.

9. The lighting apparatus according to claim 8, **characterized in that** each organic electroluminescent element has a bottom emission structure, each organic electroluminescent element comprises a transparent substrate (19) having a side face (19c) that is at least part of the side face of the organic electroluminescent element, and each organic electroluminescent element is housed in its corresponding housing section (13) so that the side face (19c) of the transparent substrate (19) contacts the guide section (16).

10. The lighting apparatus according to claim 9, **characterized in that** the organic electroluminescent elements are electrically connected in series.

11. A method of manufacturing the lighting apparatus according to claim 4, **characterized in that** the light scattering bodies (17) are formed by application of laser light.

## Patentansprüche

1. Beleuchtungsgerät mit:
einer Vielzahl von Lichtemissionselementen (14) mit jeweils einer oberen Fläche und einer Seitenfläche; und
einem optischen Element (12) mit:
einem Substratabschnitt (15), der eine Lichtübertragung mit einer ersten Oberfläche und einer zweiten Oberfläche erlaubt, wobei die erste Oberfläche und die zweite Oberfläche auf gegenüberliegenden Seiten des Substratabschnitts (15) angeordnet sind, und die erste Oberfläche als Lichtaustrittsoberfläche (15a) wirkt;
einem Leitabschnitt (16), der auf der zweiten Oberfläche des Substratabschnittes (15) bereitgestellt ist; und
einer Vielzahl von Einhäusungsabschnitten (13),
**dadurch gekennzeichnet, dass**
der Leitabschnitt eine die lateralen Seitenwände der Vielzahl von Einhäusungsabschnitten (13) definierende Rahmenform aufweist, und
jedes Lichtemissionselement (14) in einem der Einhäusungsabschnitte (13) eingehäust ist, wobei die obere Fläche des Lichtemissionselementes (14) dem Substratabschnitt (15) zugewandt ist, und die Seitenfläche des Lichtemissionselementes (14) dem Leitabschnitt (16) zugewandt ist, und von den Seitenflächen der in den Einhäusungsabschnitten (13) eingehäusten Lichtemissionselementen (14) emittiertes Licht in den Leitabschnitt (16) eindringt und zum Substratabschnitt (15) durch den Leitabschnitt (16) geleitet wird, und sodann aus dem Substratabschnitt (15) durch die Lichtaustrittsoberfläche (15a) zusammen mit dem von den oberen Flächen der Lichtemissionselemente (14) emittierten Licht austritt.

2. Beleuchtungsgerät nach Anspruch 1, **dadurch gekennzeichnet, dass** die erste Oberfläche orthogonal zu der Seitenfläche des Lichtemissionselementes (14) ist.

3. Beleuchtungsgerät nach Anspruch 1 oder 2, **dadurch gekennzeichnet, dass** der Leitabschnitt (16) mit dem Substratabschnitt (15) integriert ist.

4. Beleuchtungsgerät nach einem der Ansprüche 1 bis 3, **dadurch gekennzeichnet, dass** der Leitabschnitt (16) Lichtstreuungskörper (17) umfasst.

5. Beleuchtungsgerät nach einem der Ansprüche 1 bis 4, **dadurch gekennzeichnet, dass** der Leitabschnitt (16) einen relativ zu dem Substratabschnitt (15) am fernen Ende angeordneten Lichtreflexionsabschnitt (24) umfasst, und ein der Rahmenform des Leitabschnitts (16) entsprechender Abschnitt des Substratabschnittes (15) Lichtstreuungskörper (17) umfasst.

6. Beleuchtungsgerät nach einem der Ansprüche 1 bis 5, **dadurch gekennzeichnet, dass** der Substratabschnitt (15) einen der Rahmenform des Leitabschnitts (16) entsprechenden Abschnitt sowie einen einem Muster der lateralen Querschnitte der Vielzahl von Einhäusungsabschnitten (13) entsprechenden Abschnitt aufweist, und der der Rahmenform des Leitabschnitts (16) entsprechende Abschnitt des Substratabschnitts (15) dazu konfiguriert ist, das Licht intensiver als der dem Muster der lateralen Querschnitte der Vielzahl von Einhäusungsabschnitten (13) entsprechende Abschnitt des Substratabschnittes (15) zu streuen.

7. Beleuchtungsgerät nach einem der Ansprüche 1 bis 6, **dadurch gekennzeichnet, dass** jedes Lichtemissionselement (14) ein anorganisches Elektrolumineszenzelement ist.

8. Beleuchtungsgerät nach einem der Ansprüche 1 bis 6, **dadurch gekennzeichnet, dass** jedes Lichtemissionselement (14) ein organisches Elektrolumineszenzelement ist.

9. Beleuchtungsgerät nach Anspruch 8, **dadurch gekennzeichnet, dass** jedes organische Elektrolumineszenzelement eine Bodenemissionsstruktur aufweist, jedes organische Elektrolumineszenzelement ein transparentes Substrat (19) mit einer Seitenfläche (19c) aufweist, welche zumindest ein Teil der Seitenfläche des organischen Elektrolumineszenzelementes ist, und jedes organische Elektrolumineszenzelement in seinem entsprechenden Einhäusungsabschnitt (13) so eingehäust ist, dass die Seitenfläche (19c) des transparenten Substrats (19) mit dem Leitabschnitt (16) in Kontakt steht.

10. Beleuchtungsgerät nach Anspruch 9, **dadurch gekennzeichnet, dass** die organischen Elektrolumineszenzelemente elektrisch in Reihe geschaltet sind.

11. Verfahren zur Herstellung des Beleuchtungsgerätes nach Anspruch 4, **dadurch gekennzeichnet, dass** die Lichtstreuungskörper (17) durch die Anwendung von Laserlicht ausgebildet sind.

## Revendications

1. Dispositif d'éclairage comprenant :
une pluralité d'éléments d'émission de lumière (14) comprenant chacun une face supérieure et une face latérale, et
un élément optique (12) comprenant :
une section de substrat (15) qui permet une transmission de la lumière, ayant une première surface et une seconde surface, la première surface et la seconde surface étant sur des côtés opposés de la section de substrat (15), la première surface fonctionnant comme une surface de sortie de lumière (15a),
une section de guidage (16) prévue sur la seconde surface de la section de substrat (15), et
une pluralité de sections de logement (13),
**caractérisé en ce que**
la section de guidage présente une forme de cadre définissant les parois latérales de la pluralité de sections de logement (13) et
chaque élément d'émission de lumière (14) est logé dans l'une des sections de logement (13), la face supérieure de l'élément d'émission de lumière (14) étant orientée vers la section de substrat (15) et la face latérale de l'élément d'émission de lumière (14) étant orientée vers la section de guidage (16), et la lumière émise depuis les faces latérales des éléments d'émission de lumière (14) logées dans la section de logement (13) pénètre dans la section de guidage (16) et est guidée vers la section de substrat (15) par la section de guidage (16) et sort ensuite de la section de substrat (15) en traversant la surface de sortie de lumière (15a) en même temps que la lumière émise des faces supérieures des éléments d'émission de lumière (14).

2. Dispositif d'éclairage selon la revendication 1, **caractérisé en ce que** la première surface est orthogonale à la face latérale de l'élément d'émission de lumière (14).

3. Dispositif d'éclairage selon la revendication 1 ou 2, **caractérisé en ce que** la section de guidage (16) est solidaire de la section de substrat (15).

4. Dispositif d'éclairage selon l'une quelconque des revendications 1 à 3, **caractérisé en ce que** la section de guidage (16) comprend des corps diffusant de la lumière (17).

5. Dispositif d'éclairage selon l'une quelconque des revendications 1 à 4, **caractérisé en ce que** la section de guidage (16) comprend une partie de réflexion de lumière (24) située à l'extrémité distale par rapport à la section de substrat (15), et une partie de la section de substrat (15) correspondant à la forme de cadre de la section de guidage (16) comprend des corps diffusant de la lumière (17).

6. Dispositif d'éclairage selon l'une quelconque des revendications 1 à 5, **caractérisé en ce que** la section de substrat (15) comprend une partie correspondant à la forme de cadre de la section de guidage (16) et une partie correspondant à un motif des sections transversales latérales de la pluralité de sections de logement (13), et la partie de la section de substrat (15) correspondant à la forme de cadre de la section de guidage (16) est configurée pour diffuser la lumière plus intensément que la partie de la section de substrat (15) correspondant au motif des sections transversales latérales de la pluralité de sections de logement (13).

7. Dispositif d'éclairage selon l'une quelconque des revendications 1 à 6, **caractérisé en ce que** chaque élément d'émission de lumière (14) est un élément électroluminescent inorganique.

8. Dispositif d'éclairage selon l'une quelconque des revendications 1 à 6, **caractérisé en ce que** chaque élément d'émission de lumière (14) est un élément électroluminescent organique.

9. Dispositif d'éclairage selon la revendication 8, **caractérisé en ce que** chaque élément électroluminescent organique comporte une structure d'émission inférieure, chaque élément électroluminescent organique comprend un substrat transparent (19) ayant une face latérale (19c) qui est au moins une partie de la face latérale de l'élément électroluminescent organique, et chaque élément électroluminescent organique est logé dans sa section de logement correspondante (13) de sorte que la face latérale (19c) du substrat transparent (19) est en contact avec la section de guidage (16).

10. Dispositif d'éclairage selon la revendication 9, **caractérisé en ce que** les éléments électroluminescents organiques sont reliés électriquement en série.

11. Procédé de fabrication du dispositif d'éclairage selon la revendication 4, **caractérisé en ce que** les corps diffusant de la lumière (19) sont formés par application d'une lumière laser.
